# EUROPÄISCHE PATENTSCHRIFT

(11) **EP 1 349 279 B1**
(45) Veröffentlichungstag und Bekanntmachung des Hinweises auf die Patenterteilung: **27.04.2011**
(21) Anmeldenummer: 03007166.6
(22) Anmeldetag: 28.03.2003
(51) Int. Cl.: H03K 17/94

(54) **Optoelektronischer Berührungs- oder Näherungsschalter**
Optoelectronic touch or proximity switch
Commutateur tactile ou de proximité optoélectronique

(30) Priorität: 29.03.2002 DE 10214197; 29.03.2002 DE 10214199
(43) Veröffentlichungstag der Anmeldung: 01.10.2003
(73) Patentinhaber: Münchner Hybrid Systemtechnik GmbH, 80339 München (DE)
(72) Erfinder: Strunkeit, Claudia, 81373 München (DE); Rudrich, Hans-Peter, 81373 München (DE)
(74) Vertreter: Liesegang, Eva

(56) Entgegenhaltungen:
- EP-A- 0 551 240
- EP-A- 0 759 660
- US-A1- 2002 020 808

## Beschreibung

Die Erfindung betrifft einen Berührungs- oder Näherungsschalter mit einer optoelektronischen Sensoranordnung mit einem Strahler, der in einem lichtdurchlässigen Gehäuse angeordnet ist und einen Lichtstrahl aussendet, und mit einem fotosensitiven Element als Empfänger, das außerhalb des Strahlengangs des Lichtstrahls angeordnet ist. Die optoelektronische Sensoranordnung wird als Betätigungsmittel und zur Beleuchtung des Schalters verwendet.

Betätigungselemente für Schalter basieren herkömmlich auf mechanischen Bedienelementen. Solche mechanischen Bedienelemente haben einen vergleichsweise großen Platzbedarf und sind anfällig gegenüber ungünstigen Umwelteinflüssen, wie Feuchtigkeit durch beispielsweise Kondensation und tiefe Temperaturen. Neben mechanischen Bedienelementen für Schalter kommen wegen ihres einfachen Fertigungs- und Montageaufwandes und den steigenden Anforderungen an die Zuverlässigkeit und den Komfort der Bedienbarkeit bei unterschiedlichen Umgebungsbedingungen immer häufiger Berührungsschalter auf der Basis von kapazitiven oder optoelektronischen Sensoren zur Anwendung. Das kapazitive Schaltprinzip basiert auf für den Schaltvorgang notwendigen Potentialunterschieden in der Umgebung des Schaltgeräts, welche nicht immer vorhanden sind. Bei den Bedienelementen auf optoelektronischer Basis wird zwischen passiven und aktiven Sensoren unterschieden. In passiven Sensoren kommt nur ein Fotoempfänger oder ein gegenüber Temperaturstrahlung sensitives Element zum Einsatz, während aktive Sensoren einen Strahler und einen fotosensitiven Empfänger aufweisen, wobei der Strahler einen gerichteten Strahl aussendet und der Empfänger die reflektierte Strahlung erfaßt. Hieraus ergibt sich die Möglichkeit, Näherungssensoren zu schaffen, die berührungslos und kontaktlos arbeiten. Solche optoelektronischen Sensoren, die auch als Reflexlichttaster bezeichnet werden, sind z.B. in den Druckschriften DE 42 07 772 A1 und DE 195 47 301 C1 beschrieben und weisen im Vergleich zu passiven Sensoren eine erhöhte Signalsicherheit bei einem geringen Energiebedarf auf.

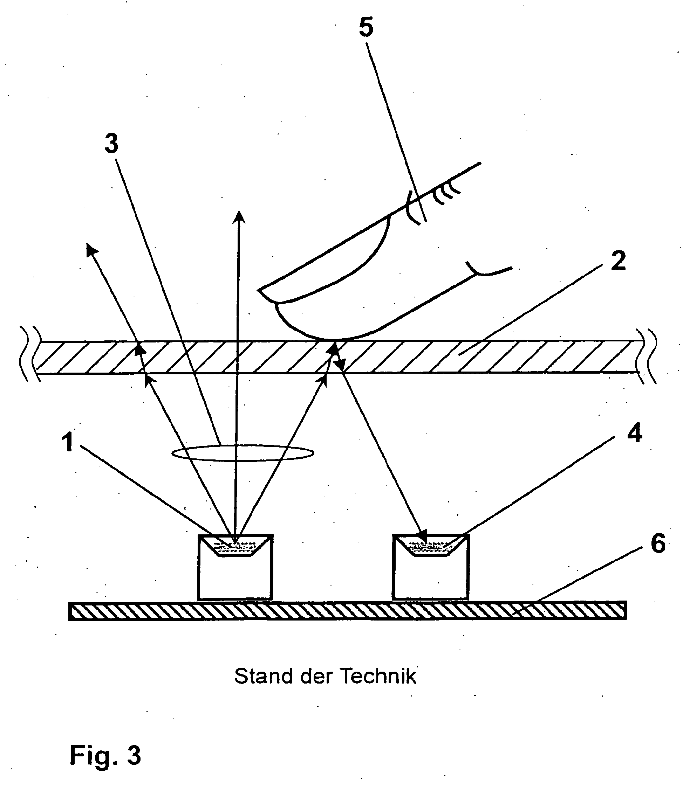

Ein Beispiel eines optoelektronischen Schalters, der als Reflexlichttaster arbeitet, ist auch in Fig. 3 gezeigt. Der Reflexlichttaster weist einen Strahler 1 auf, der einen Lichtstrahl 3 abgibt, sowie ein fotosensitives Element 4 als Empfänger, welches den reflektierten Lichtstrahl 3 erfaßt. Strahler 1 und Empfänger 4 sind mit einem gewissen Abstand auf einem Träger oder Substrat 6 angeordnet, um sicherzustellen, daß der Empfänger 4 nicht aufgrund seitlicher Abstrahlung des Lichtstrahls 3 eine Fehlmessung durchführt. Dieser Reflexlichttaster weist ferner ein Gehäuse 2 auf, das schematisch durch ein Teil der Gehäusewand dargestellt ist. Die Gehäusewand des Gehäuses 2 bildet eine Betätigungsfläche, um durch Berühren dieser Betätigungsfläche mit einem Gegenstand, beispielsweise einem Finger 5, den Lichtstrahl 3 des Strahlers 1 auf den Empfänger 4 zu reflektieren und so den zugehörigen Schalter zu betätigen. Klar ist, daß in jedem Fall nur ein Bruchteil der vom Strahler 1 emittierten Strahlung auf den Empfänger 4 zurückreflektiert wird.

Ein Nachteil des Standes der Technik ist, daß der Sensoraufbau nach wie vor einen relativ großen Platzbedarf hat, weil sowohl zwischen dem Empfänger 4 und der Berührungsfläche 2 als auch zwischen dem Strahler 1 und dem Empfänger 4 ausreichend Abstand gehalten werden muß, um ein sicheres Ausgangssignal erzielen zu können. Damit sind aber auch der Integration von Strahler und Empfänger in einem Gehäuse oder auf einem Chip deutliche Grenzen gesetzt, was wiederum einer weiteren Kostensenkung des Fertigungs- und Montageaufwandes entgegensteht. Eine weitere Möglichkeit besteht darin, zwischen Strahler 1 und Empfänger 4 eine lichtundurchlässige Abtrennung einzufügen, um eine direkte Einstrahlung des Strahlers 1 auf den Empfänger 4 auszuschließen. Dies verursacht jedoch ebenfalls einen nicht zu vernachlässigenden konstruktiven und fertigungstechnischen Aufwand und steht einer miniaturisierten und preiswerten Realisierung derartiger Systeme entgegen.

Grundsätzlich besteht bei Schaltern und insbesondere bei Berührungs- und Näherungsschaltern häufig der Wunsch, daß der Benutzer den Schalter auch im Dunkeln finden und schnell und sicher bedienen kann. Dazu weisen die bekannten Schalter gelegentlich eine separate Beleuchtungseinrichtung auf, die durch eine zusätzliche Lichtquelle sowohl innerhalb des Schalters, unter der Betätigungsfläche als auch außerhalb des Schalters bereitgestellt werden kann. Vorteilhafte Beleuchtungsvarianten basieren neben der früher nahezu ausschließlichen Verwendung von Glimmlampen neuerdings auf dem Einsatz von Leuchtdioden. Diese haben bei einer hohen Zuverlässigkeit ebenfalls infolge des hohen Lichtwirkungsgrades einen besonders geringen Energieverbrauch. Auch sind Leuchtdioden besonders langlebig und weitestgehend wartungsfrei sowei einfach anzusteuern. Die Patentschrift DE 39 31 668 C2 zeigt eine Möglichkeit von Beleuchtungsvorrichtungen für Anzeigetafeln unter Verwendung von Leuchtdioden. In der Offenlegungsschrift DE 100 20 960 A1 wird beschrieben, wie mittels eines IR-Passivbewegungssensors eine Lichtquelle in einem Schließzylinder bei Annäherung gesteuert wird. Ebenfalls ein Näherungsschalter wird in der Patentschrift DE 42 32 972 C2 verwendet, um die Beleuchtung für Bedienelemente zu aktivieren. Festzustellen ist aber, daß auf jeden Fall eine separate Beleuchtungsvorrichtung notwendig ist, was bei erhöhtem Platzbedarf einen zusätzlichen Herstellungs- und Fertigungsaufwand bedarf.

EP 0 243 411 beschreibt einen beleuchtbaren sensitiven Schalter, insbesondere eine berührungsempfindliche LED, die in einer der dargestellten Ausführungsformen eine lichtempfindliche Fotodiode und eine lichtsendende Diode innerhalb ein und desselben Gehäuses auf einem Substrat aufweist. Licht von der lichtsendenden Diode wird bei Annäherung eines Gegenstands auf die Fotodiode zurückreflektiert. Verschiedene Schaltzustände werden durch verschiedene Intensitäten oder Blinkfrequenzen der lichtsendenden Diode dargestellt.

DE 198 12 555 beschreibt eine Vorrichtung zur berührungslosen Steuerung einer Lichtquelle. Das Ein- und Ausschalten der Lichtquelle erfolgt durch kurzzeitiges Beeinflussen des Strahlengangs der Lichtschranke zwischen einem Strahler und einem lichtempfindlichen Element. In dieser Schrift ist eine zusätzliche Lichtquelle vorgesehen, die als Orientierungshilfe dient. Eine ähnliche Vorrichtung, jedoch ohne Orientierungshilfe, ist in der DE 199 52 795 beschrieben.

EP 0 551 240 A1 beschreibt einen Berührungsschalter mit einer optoelektronischen Sensoranordnung, die einen in einem lichtdurchlässigen Gehäuse angeordneten Strahler und einen fotosensitiven Empfänger umfasst. Der Berührungsschalter umfasst außerdem eine lichtdurchlässige Platte als Berührungsfläche, die über der optoelektronischen Sensoranordnung angeordnet ist.

Es ist eine Aufgabe der Erfindung, einen Berührungs- oder Näherungsschalter, der eine solche optoelektronische Sensoranordnung verwendet, anzugeben, der einen kompakten Aufbau hat und mit geringem Material- und Fertigungsaufwand hergestellt werden kann.

Diese Aufgabe wird durch einen Berührungs- oder Näherungsschalter gemäß Anspruch 1 gelöst. Vorteilhafte Weiterbildungen der Erfindung sind in den abhängigen Ansprüchen angegeben.

Die Erfindung sieht einen Berührungs- oder Näherungsschalter mit einer optoelektronischen Sensoranordnung mit einem Strahler, der in einem lichtdurchlässigen LED-O Gehäuse angeordnet ist und einen Lichtstrahl aussendet, und einem fotosensitiven Element als Empfänger, das außerhalb des primären Strahlengangs des Lichtstrahls des Strahlers angeordnet ist, vor. Im Strahlengang des Lichtstrahls ist eine lichtdurchlässige Fläche angeordnet, die bei Berührung oder Annäherung eine Reflektion des Lichtstrahls auf das fotosensitive Element bewirkt. Diese lichtdurchlässige Fläche ist durch eine Kuppel des LED-Gehäuses selbst gebildet, wobei das lichtdurchlässige LED-O Gehäuse sowohl für das emittierte als auch für den ggf. reflektierten Teil der Strahlung als Lichtleiter wirkt. Das fotosensitive Element ist im unmittelbaren Bereich des Gehäuses und außerhalb des Gehäuses, vorzugsweise in Abstrahlrichtung des Strahlers hinter dem Strahler angeordnet. Zur Realisierung des erfindungsgemäßen Schalters wird die Lichtleiterfunktion des lichtdurchlässigen Gehäuses des Strahlers ausgenutzt, und zwar nicht nur, um das Licht vom Strahler in Abstrahlrichtung nach vorne zu bündeln und auszukoppeln, sondern auch, um ggf. reflektiertes Licht bis zum Empfänger zurückzuleiten. Außerhalb des lichtdurchlässigen Gehäuses reflektiertes Licht dringt dabei durch die lichtdurchlässige Fläche in das Gehäuse ein und wird ebenso wie an der lichtdurchlässigen Fläche reflektiertes Licht durch das Gehäuse hindurch bis zur Bodenplatte geleitet, wo es wieder austritt und wo das reflektierte Licht gezielt in den Empfänger außerhalb des Gehäuses eingekoppelt werden kann. Aufgrund der gezielten Ausnutzung der Lichtleiterfunktion des lichtdurchlässigen Gehäuses kann der Empfänger in unmittelbarer Nähe des Gehäuses angeordnet werden, wobei jedoch sinnvoll ist, daß er in Abstrahlrichtung hinter dem Sender angeordnet ist.

Erfindungsgemäß ist das fotosensitive Element (Empfänger) in Abstrahlrichtung des Strahlers hinter dem lichtdurchlässigen Gehäuse angeordnet. Durch die Anordnung des fotosensitiven Elements außerhalb des Gehäuses des Strahlers ergibt sich eine besonders kostengünstige Ausführung der Sensoranordnung bei gleichzeitig geringem Platzbedarf.

Vorzugsweise wird ein Strahler verwendet, der einen Lichtstrahl im sichtbaren Bereich erzeugt. In diesem Fall kann der Strahler der Sensoranordnung gleichzeitig als Orientierungsleuchte oder Hilfsbeleuchtung oder sogar als Leuchtmittel oder Schaltzustandsanzeige verwendet werden.

Erfindungsgemäß sind der Strahler als mindestens eine LED und das fotosensitive Element als Fotodiode oder Fototransistor vorzugsweise in SMD Bauform ausgestaltet.

Mit der beschriebenen optoelektronischen Sensoranordnung ist es möglich, unter Verwendung eines Minimums an Bauteilen einen sehr kompakten Sensor aufzubauen, der keine optoelektronischen Spezialbauteile benötigt, sondern vollständig durch Standardbauteile, wie LEDs oder Fototransistoren, realisiert werden kann. Der Fertigungs- und Montageaufwand ist minimal.

In einer weiteren Ausführungsform umfasst der Schalter zusätzlich eine elektronische Steuereinheit für die optoelektronische Sensoranordnung, welche den Strahler wahlweise zum Aussenden des Lichtstrahls als einen Licht-Meßstrahl und zur Beleuchtung des Schalters ansteuert und welche den Schalter abhängig vom Ausgangssignal des fotosensitiven Elementes betätigt.

In einer vorteilhaften Ausführungsform der Erfindung kann die Steuereinheit das fotosensitive Element wahlweise als Berührungs- oder Näherungs-Detektor (Reflexionssignal-Detektor) und auch als Umgebungslicht-Detektor beispielsweise als einen Dämmerungsdetektor betreiben, wie unten noch näher erläutert ist.

Um die verschiedenen Funktionen des erfindungsgemäßen Schalters, als Betätigungsmittel und zur Beleuchtung des Schalters, zu realisieren, ist erfindungsgemäß vorgesehen, daß das fotosensitive Element und der Strahler von der elektronischen Steuereinheit gemeinsam getaktet werden, wobei der Takt zumindest in regelmäßigen Intervallen einen Meßzyklus und einen Arbeitszyklus umfaßt. In einer Ausführungsform der Erfindung kann der Takt während jeder Periode einen Meßzyklus und einen Arbeitszykluß umfassen. In einer anderen Ausführungsform ist es möglich, daß Meßzyklen nur in regelmäßigen Intervallen der Taktperiode auftreten. Während des Meßzyklusses kann das fotosensitive Element einmal als Umgebungslicht-Detektor verwendet werden, währenddessen der Strahler grundsätzlich deaktiviert ist, und ein weiteres mal erfolgt eine Verwendung des fotosensitiven Elementes als Reflexionssignal-Detektor, währenddessen der Strahler mindestens einen Meßimpuls abgibt. Während des Arbeitszyklusses kann der Strahler von der elektronischen Steuereinheit als Leuchtmittel angesteuert werden. Dabei kann das Leuchtmittel als Anzeige für den Schaltzustand des Schalters eingesetzt werden oder als gesteuerte Beleuchtung für den Schalter fungieren, indem in Abhängigkeit vom Meßergebnis des Umgebungslicht-Detektors die Ein- bzw. Ausschaltung des Leuchtmittels über die elektronische Steuereinheit vorgenommen wird.

In einer einfacheren Variante weist der Schalter eine Hilfsbeleuchtung auf, die durch den Strahler der Sensoranordnung selbst gebildet ist und die unabhängig von der Umgebungshelligkeit angesteuert wird. Die Steuereinheit kann diese Hilfsbeleuchtung des Schalters abhängig von einem Schaltsignal aktivieren. Beispielsweise kann der Strahler als Hilfsbeleuchtung immer dann eingeschaltet sein, wenn das zu schaltende Leuchtmittel ausgeschaltet ist, oder er kann abhängig von anderen externen Signalen ein- und ausgeschaltet werden. In der bevorzugten Ausführungsform der Erfindung steuert die Steuereinheit den Strahler zur Beleuchtung des Schalters jedoch abhängig von dem Signal des Umgebungslicht-Detektors automatisch an, wenn bestimmte Helligkeitsschwellwerte unter- bzw. überschritten sind. Die "Intensität" oder Helligkeit der Hilfsbeleuchtung kann dabei auf einfache Weise durch eine Änderung der Zeitdauer der Ansteuerung des Strahlers während des Arbeitszyklus gesteuert werden (Pulsweitenmodulation, Pulsdauermodulation).

Eine vorteilhafte technische Lösung für die Unterscheidung der abweichenden Verwendung des Leuchtmittels liegt dann vor, wenn diese durch eine unterschiedliche Helligkeit signalisiert wird. Dies erfolgt besonders einfach dadurch, daß der Zeitbereich für die Aktivierung des Leuchtmittels als Anzeige für den Schaltzustand des Schalters länger ist als der Zeitbereich für die Aktivierung des Leuchtmittels als Beleuchtung für den Schalter.

Eine andere Variante ist dadurch gegeben, daß zur Kennzeichnung, ob das Leuchtmittel als Anzeige für den Schaltzustand des Schalters oder als Beleuchtung für den Schalter betrieben wird, die Farbe des Leuchtmittels umschaltbar gestaltet ist.

Eine günstige Ausgestaltungsmöglichkeit für die Ansteuerung des fotosensitiven Elementes ergibt sich dadurch, daß dieses mit unterschiedlichen Empfindlichkeiten betrieben wird, wobei bei der Verwendung als Umgebungslicht-Detektor eine höhere Empfindlichkeit sinnvoll ist.

Als kostengünstig erweist sich prinzipiell, dass es sich beim dem Strahler um mindestens eine LED und bei dem fotosensitiven Element um eine Fotodiode oder um einen Fototransistor handelt. Die Empfindlichkeitsänderung des fotosensitiven Elementes wird dann durch die zeitweise Änderung eines Arbeitswiderstandes erzeugt. Aber auch kann die mindestens eine LED als Mehrfarben-LED gestaltet sein.

Der erfindungsgemäße Strahler kann eine Lichtquelle sein, die sichtbares Licht in dem gesamten sichtbaren Lichtspektrum, d.h. im Bereich von 400 bis 800 Nanometer Wellenlänge oder auch darüber hinaus, aussendet. Vorzugsweise sendet der Strahler nicht nur monochromatische sondern breitbandigere sichtbare Strahlung wie beispielsweise weißes Licht aus.

Die Erfindung schafft somit einen Berührungs- oder Näherungsschalter, der mit geringem Aufwand an Material und Herstellungskosten gefertigt werden kann. Bei Verwendung geeigneter Bauteile für die Sensoranordnung, wie LED im 3mm oder 5mm Gehäuse, Fotodioden und Fototransistoren beispielsweise im SMD-Gehäuse, wird eine hohe Zuverlässigkeit bei minimalem Energiebedarf erreicht. Der Strahler kann als Hilfsbeleuchtung bei Bedarf nahezu ständig aktiviert sein, ohne daß dadurch nennenswerte Energieverluste entstehen. Die Hilfsbeleuchtung kann einerseits als Orientierungslicht für die Bedienung des Schalters, zugleich aber auch als Hilfsbeleuchtung für die engere Umgebung des Schalters im Dunkeln dienen. Zum Ein- und Ausschalten muß der Schalter lediglich mit einem Gegenstand, wie einem Finger, berührt oder angenähert werden, um die Sensoranordnung zu aktivieren und somit den Schalter zu betätigen.

Eine weitere Senkung des Energiebedarfs entsteht durch Verwendung der Sensoranordnung auch als Dämmerungsschalter und durch automatisches Ansteuern des Strahlers als Hilfsbeleuchtung abhängig von der erfaßten Umgebungshelligkeit. Dabei ist auch denkbar, daß abhängig von der Definition unterschiedlicher Schaltschwellen die Hilfsbeleuchtung in unterschiedlichen Dimmstufen abhängig von der Umgebungshelligkeit oder direkt oder auch umgekehrt proportional zur erfaßten Umgebungshelligkeit angesteuert wird.

Die Erfindung ist im folgenden anhand bevorzugter Ausführungsformen mit Bezug auf die Zeichnungen näher erläutert. Es zeigen:
- Fig.1: die optoelektronische Sensoranordnung integriert in einem Gehäuse auf einem gemeinsamen Träger zur Erläuterung der Grundlagen der Erfindung,
- Fig.2a: die optoelektronische Sensoranordnung gemäß der Erfindung ohne Fingerberührung,
- Fig.2b: die optoelektronische Sensoranordnung gemäß der Erfindung mit Fingerberührung,
- Fig.3: die optoelektronische Sensoranordnung nach dem Stand der Technik,
- Fig.4: ein Blockschaltbild eines beleuchtbaren sensitiven Schalters,

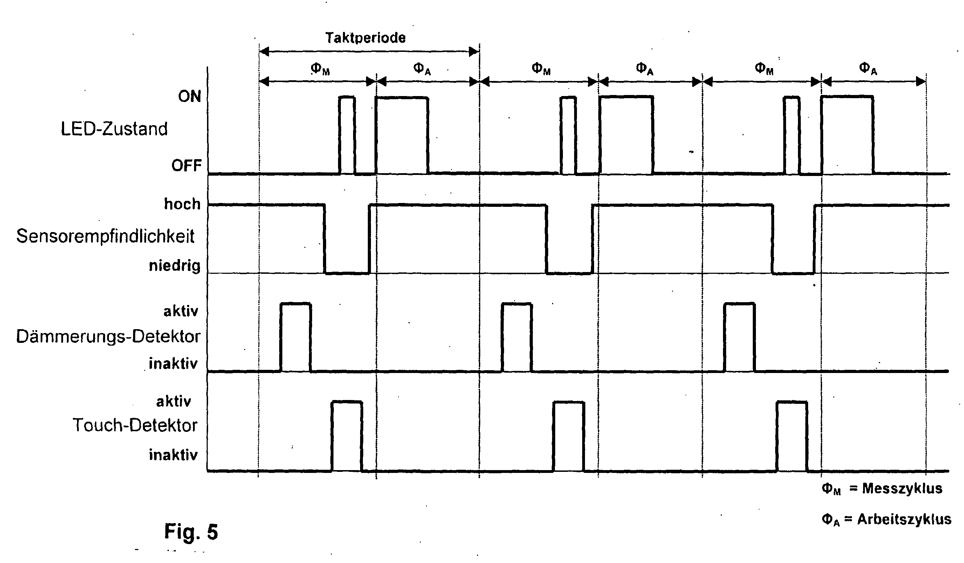

- Fig.5: den Signalverlauf bei Beleuchtung des Schalters,

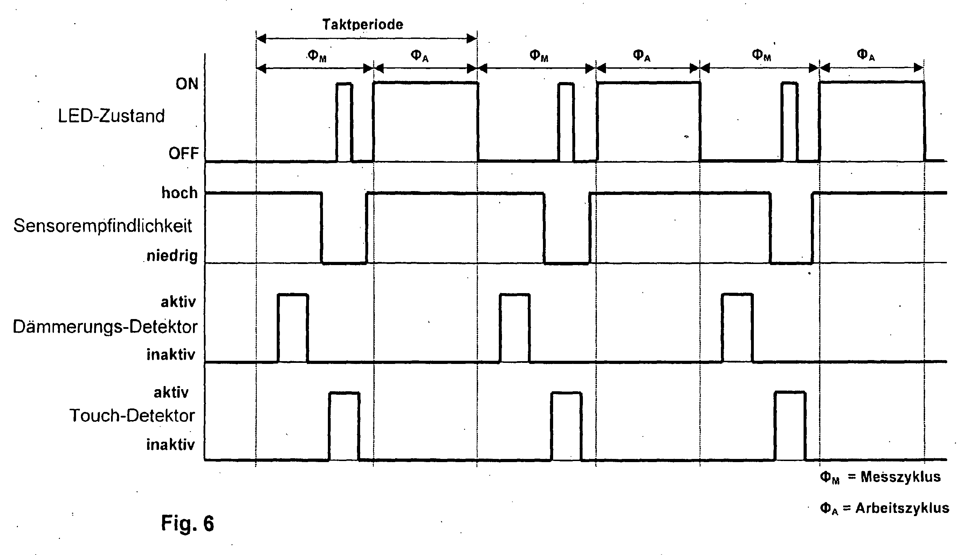

- Fig.6: den Signalverlauf bei Anzeige des Schaltzustandes "ON" des Schalters.

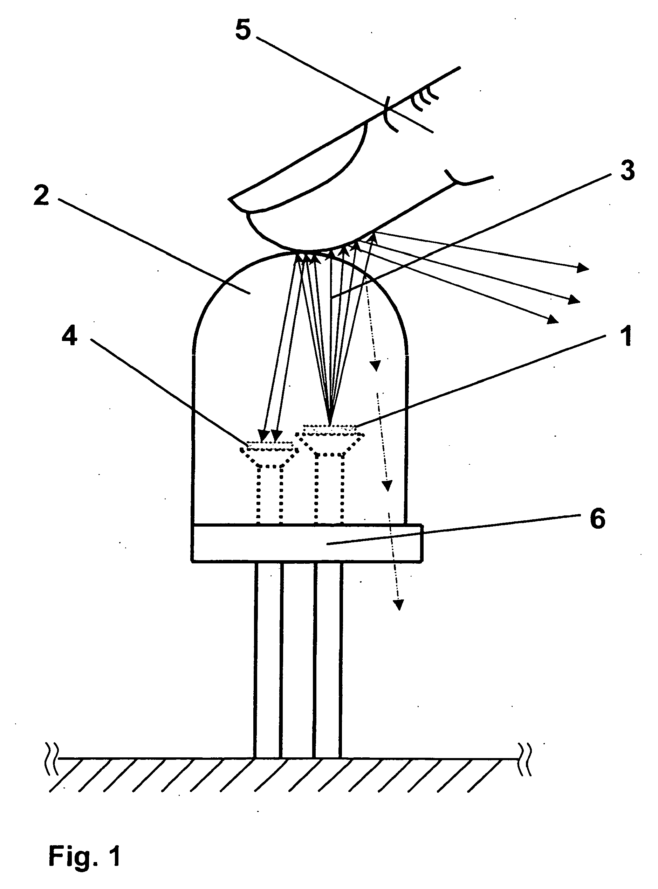

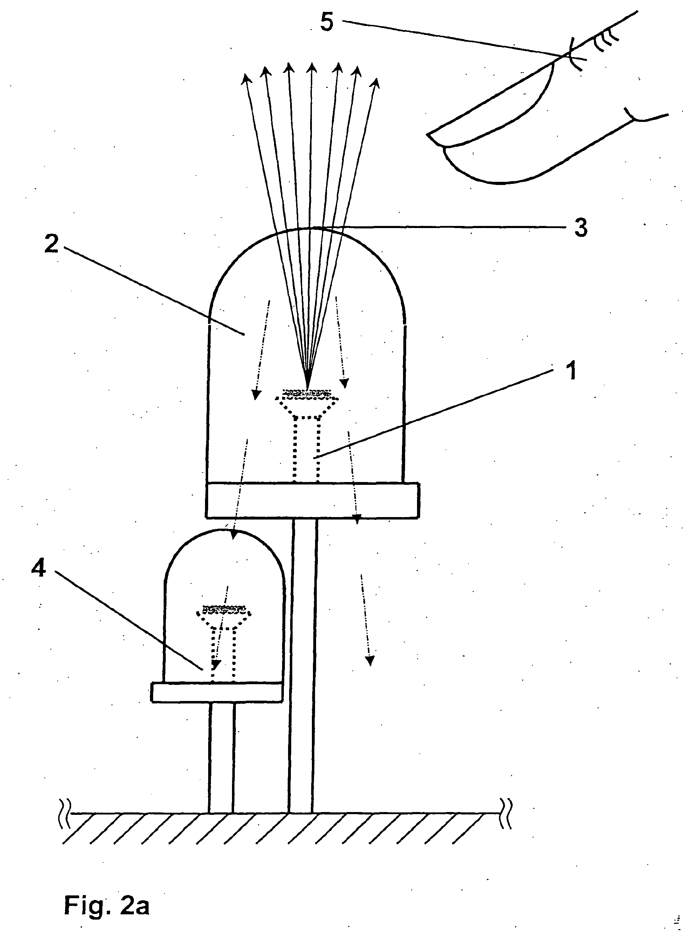

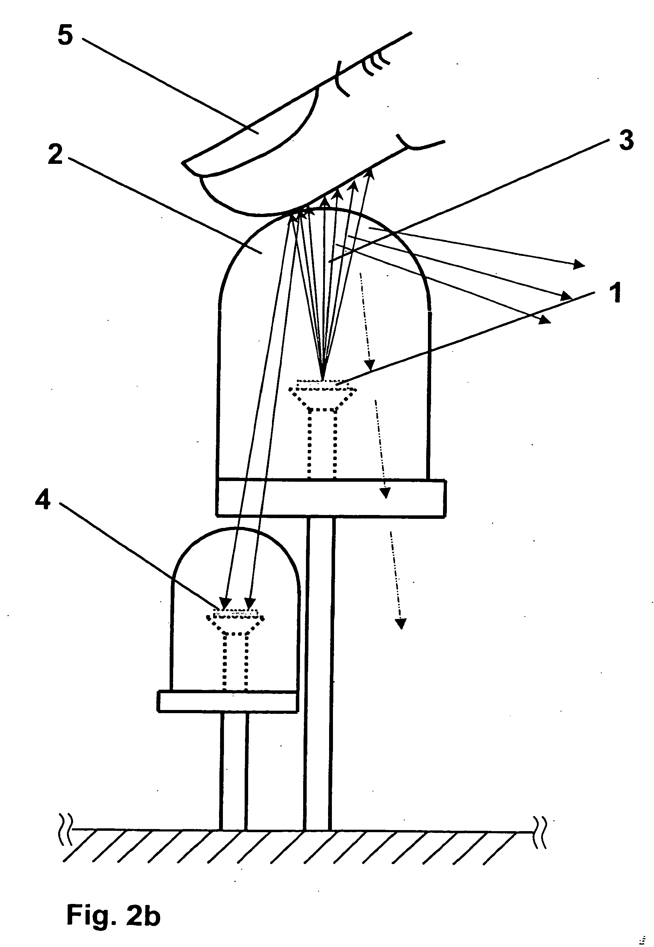

Die in Fig. 1 dargestellte optoelektronische Sensoranordnung besteht aus einem Strahler 1, der einen gerichteten Strahlengang 3 aufweist, und einem fotosensitiven Element 4, das sich außerhalb des Strahlenganges 3 befindet, wobei beide optoelektronischen Bauelemente 1, 4 in einem Gehäuse 2 auf einem Träger 6 bzw. einem Substrat 6 angeordnet sind und gemeinsam von einem lichtdurchlässigen Gehäuse 2 überdeckt werden. So lange keine Berührung des Gehäuses 2 oder eine Annäherung an das Gehäuse 2 durch beispielsweise einen Finger 5 erfolgt, siehe Fig. 1, können die Lichtstrahlen großteils ungehindert das Gehäuse 2 verlassen, so daß der Strahler 1, auch gleichzeitig als Leucht- oder Orientierungsmittel dienen kann, sofern Strahler verwendet werden, die im sichtbaren Bereich arbeiten. Wird nun das lichtdurchlässige Gehäuse 2 durch z. B. einen Finger 5 berührt bzw. dieser in unmittelbare Nähe zum Gehäuse 2 gebracht, siehe Fig. 2 b, dann wird der gerichtete Strahlengang 3 vermehrt reflektiert und trifft vermehrt auf das fotosensitive Element 4. Das lichtdurchlässige Gehäuse 2 bildet somit einen Lichtleiter. Infolgedessen erzeugt das fotosensitive Element 4 ein erhöhtes Ausgangssignal, was eben die Berührung des Gehäuses 2 und damit die Betätigung der optoelektronischen Sensoranordnung signalisiert. Diese Signaländerung kann dann ohne weiteres an ein Schaltgerät weitergeleitet werden, das eine EIN/AUS-Schaltung betätigt.

In den Fig. 2a ist eine besonders kostengünstige und einfache Ausführung der erfinderischen optoelektronischen Sensoranordnung angegeben. Hier handelt es sich bei dem Strahler 1 um eine LED und bei dem fotosensitiven Element 4 um einen Fototransistor. Dieser Fototransistor ist unterhalb der LED in unmittelbarer Nähe zum lichtdurchlässigen Gehäuse 2 angeordnet. Auch in diesem Fall wird bei Berührung des Gehäuses 2 der LED der Strahlengang 3 der LED an der Grenzfläche von Gehäuse 2 und Finger 5 reflektiert, siehe Fig. 2 b, und trifft, da das Gehäuse 2 als Lichtleiter wirkt, auf den Fototransistor. Dessen Ausgangssignal wird wiederum zum Schaltgerät zur Weiterverarbeitung weitergeleitet. Das Gehäuse 2 der LED wirkt als ein echter Lichtleiter, der das bei der Kuppel des Gehäuses 2 eintretende bzw. reflektierte Licht durch das Gehäuse hindurch bis zur Bodenplatte leitet, wo es an den Grenzflächen nach unten und zur Seite hin abgegeben wird.

Eine besonders vorteilhafte Ausgestaltung der erfindungsgemäßen Anordnung ergibt sich dann, wenn das fotosensitive Element 4 als SMD-Bauelemente ausgeführt ist.

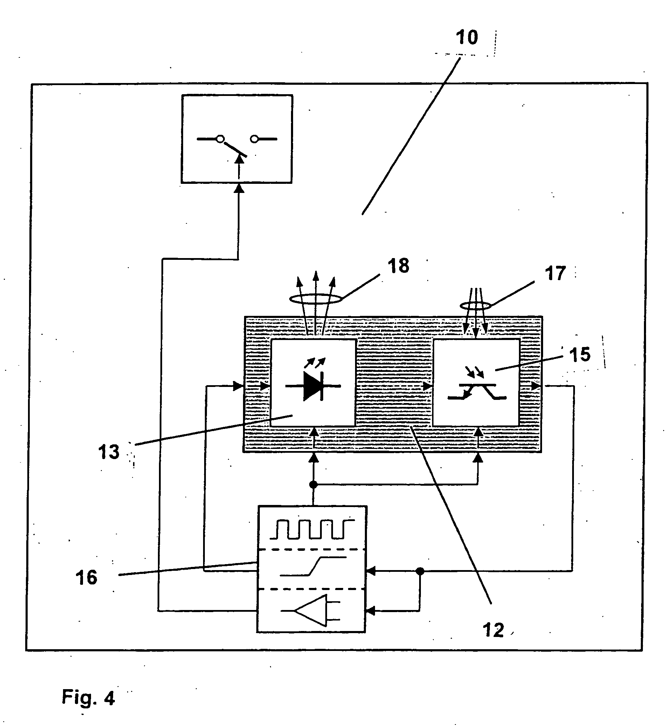

Eine solche, wie in Fig. 2 dargestellte, optoelektronische Sensoranordnung findet Anwendung als Betätigungsmittel in dem erfindungsgemäßen beleuchtbaren sensitiven Schalter 10, dessen Funktionsweise nachfolgend an Hand des Blockschaltbildes gemäß Fig. 4 beschrieben wird. Dem Schalter 10 ist als Betätigungsmittel eine optoelektronische Sensoranordnung 12 zugeordnet, wobei diese einen Strahler 13 und ein fotosensitives Element 15 enthält. Angesteuert wird die optoelektronische Sensoranordnung 12 von einer elektronischen Steuereinheit 16, wobei diese die optoelektronische Sensoranordnung 12 so beeinflußt, daß das fotosensitive Element 15 entweder als Reflexionssignal-Detektor (oder Berührungs- und Näherungs-Detektor) oder als Umgebungslicht-Detektor (oder Dämmerungs-Detektor) 17 verwendet werden kann, und zugleich kann die elektronische Steuereinheit 16 den Strahler 13 auch als Leuchtmittel 18 betreiben.

Eine einfach verständliche Variante zur Realisierung dieser Mehrfachverwendung der optoelektronischen Sensoranordnung 12 besteht darin, daß sowohl der Strahler 13 als auch das fotosensitive Element 15 mit einem gemeinsamen Takt betrieben werden, wobei in diesem Beispiel jeder Takt einen Meßzyklus und einen Arbeitszyklus beinhaltet. Während des Meßzyklus wird das fotosensitive Element 15 einmal als Umgebungslicht-Detektor 17 verwendet, währenddessen der Strahler 13 grundsätzlich deaktiviert ist. Die optoelektronische Sensoranordnung 12 arbeitet somit als Umgebungslicht-Detektor 17. In der Regel nachfolgend noch während des Meßzyklus wird dann das fotosensitive Element 15 als Reflexionssignal-Detektor betrieben, währenddessen der Strahler 13 mindestens einen Meßimpuls abgibt. Damit wird der Betrieb der optoelektronischen Sensoranordnung 12 als Betätigungselement für den Schalter 10 gewährleistet. Der Arbeitszyklus dagegen ist vorgesehen, um den Strahler 13 als Leuchtmittel 18 betreiben zu können. Dabei wird zwischen der Verwendung des Strahlers 13 als Beleuchtung für den Schalter 1 oder als Anzeige des Schaltzustandes des Schalters 10 unterschieden.

Die Beleuchtung des Schalters 10 wird dadurch realisiert, daß, wie bereits ausgerührt, das fotosensitive Element 15 in einem Teilbereich des Meßzyklusses als Umgebungslicht-Detektor 17 verwendet wird, wobei das ermittelte Meßsignal an die elektronische Steuereinheit 16 weitergeleitet wird. Wird ein vorgegebener Schwellwert überschritten, so wird der Zustand Tageslicht erkannt und die elektronische Steuereinheit 16 deaktiviert beispielsweise den Beleuchtungsmodus für den Schalter 10. Dagegen, wird durch das Ausgangssignal des Umgebungslicht-Detektors 17 ein vorgegebener Schwellwert unterschritten, so ist dies ein Zeichen für beginnende Dunkelheit bzw. bereits vollzogene Dunkelheit. Um somit die Beleuchtung des Schalters 10 einzuschalten, steuert die elektronische Steuereinheit 16 den Strahler 13 auch während des Arbeitszyklusses so an, daß der Strahler 13 während dieses Taktbereiches sichtbares Licht abgibt und somit als Leuchtmittel 18 zur Beleuchtung des Schalters 10 fungiert. Der Signalverlauf bei Beleuchtung des Schalters 10 ist in Fig. 3 gezeigt.

Der Strahler 13 als Leuchtmittel 18 kann aber auch dazu dienen, den Schaltzustand des Schalters 10 anzuzeigen, wie die Fig. 4 es zeigt. Wird nämlich im Meßzyklus, in dem die optoelektronische Sensoranordnung 12 als Reflexionssignal-Detektor für den Schalter 10 arbeitet, ein gewollter Einschaltvorgang des Schalters 10 durch die elektronische Steuereinheit 16 erkannt, so wird nicht nur der Schalter 10 selbst betätigt, sondern die elektronische Steuereinheit 16 steuert auch den Strahler 13 als Leuchtmittel 18 für eine Anzeige des Schaltzustandes "ON" des Schalters 10 so an, daß während des Arbeitszyklusses der Strahler 13 für einen bestimmten Zeitbereich aktiviert wird. Damit kann durch das intensivere Leuchten des Strahlers 13 signalisiert werden, daß der Schalter 10 im "ON-Zustand" ist.

Um den Zustand "Beleuchtung des Schalters 10" von dem Zustand "Anzeige des Schaltzustandes des Schalters 10" unterscheiden zu können, werden, wie der Vergleich der Fig. 3 und 4 zeigt, die unterschiedlichen Helligkeiten des Leuchtmittels 18 so realisiert, daß eben der Zeitbereich für die Aktivierung des Leuchtmittels 18 als Anzeige des Schaltzustandes des Schalters 1 beispielsweise doppelt so lang gewählt ist, wie der Zeitbereich für die Aktivierung des Leuchtmittels 18 als reine Beleuchtung des Schalters 10. Im "ON-Zustand" des Schalters 10 leuchtet dieser also deutlich heller.

Im Übrigen ist es aber jederzeit möglich, die Beleuchtungsfunktion des Schalters 10 unabhängig von dem Umgebungslicht-Detektor 17 zu gestalten.

Klar ist, daß die Zeitdauer der Taktfolgen Meßzyklus und Arbeitszyklus nahezu beliebig variiert werden können oder die Abfolge von Meßzyklus und Arbeitszyklus nicht unbedingt zwingend alternierend aufeinanderfolgend sein muß.

In einer alternativen, einfacheren Ausführung der Erfindung ist die Sensoranordnung ohne die Umgebungslicht-Detektorfunktion realisiert. Auch in diesem Beispiel definiert die Steuereinheit einen Meßzyklus und einen Arbeitszyklus. Während des Meßzyklus gibt der Strahler 13 wenigstens einen Meßlichtstrahl aus, und das reflektierte Licht wird von dem fotosensitiven Element 15 in seiner Funktion als Reflexionssignal-Detektor erfaßt. Die elektronische Steuereinheit 16 erkennt, anhand des durch das reflektiete Licht verursachten Pegels des Ausgangssignals des fotosensitiven Elements 15, ob ein Schaltvorgang zum Umschalten des Schalters ausgelöst werden soll. Während des Arbeitszyklus kann die Steuereinheit den Strahler 13 entweder immer ansteuern, so daß er ständig als eine Hilfsbeleuchtung aktiviert ist, oder abhängig von externen Bedingungen ansteuern. Beispielsweise kann definiert werden, daß die Hilfsbeleuchtung immer dann eingeschaltet werden soll, wenn der Schalter ausgeschaltet ist, oder umgekehrt. Es ist auch denkbar, die Hilfsbeleuchtung während des Arbeitszyklus immer für eine vorgegebene Zeit nach dem Umschalten des Schalters einzuschalten, um damit eine Rückmeldung (Quittierung) für nicht unmittelbar sofort vom Anwender feststellbare Schaltvorgänge, wie beispielsweise dem Einschalten eines trägen oder entfernten Verbrauchers zu gewährleisten.

Wesentlich bei der Erfindung ist, daß ein und derselbe Strahler 13 in einem Zeit-Multiplexverfahren, durch Definieren eines Meßzyklus und eines Arbeitszyklus, einmal als Hilfsbeleuchtung und einmal als Sender der Sensoranordnung verwendet wird. Zusätzlich sieht die Erfindung vor, daß die Sensoranordnung während des Meßzyklus sowohl als Umgebungslicht-Detektor als auch als Reflexionssignal- Detektor arbeiten kann.

Wird als Leuchtmittel 18 eine Mehrfarben-LED, z. B. Zweifarben-LED "gelb/grün", verwendet, so kann zur Unterscheidung der beiden genannten Zustände auch ein Farbwechsel genutzt werden. Leuchtet die LED nicht, so ist der Schalter 10 bei Tageslicht im "OFF-Zustand". Bei Dunkelheit wird zur Beleuchtung des Schalters 10 die LED so aktiviert, daß diese gelb leuchtet, obwohl der Schalter 10 noch im "OFF-Zustand" ist. Wird dagegen der Schalter 10 betätigt, dann leuchtet die LED mit grüner Farbe zur Anzeige des Schaltzustands, und dient dabei gleichzeitig wiederum zur Beleuchtung des Schalters 10.

Besonders als günstig erweist es sich, wenn die elektronische Steuereinheit 6 das fotosensitive Element 15 mit unterschiedlicher Empfindlichkeit betreibt, wobei bei der Verwendung des fotosensitiven Elementes 15 als Umgebungslicht-Detektor 17 eine höhere Empfindlichkeit eingestellt wird. Handelt es bei dem fotosensitiven Element 15 um eine Fotodiode oder um einen Fototransistor, dann läßt sich diese Empfindlichkeitsänderung des fotosensitiven Elementes 15 in einfacher Weise durch die zeitweise Änderung des zugehörigen Arbeitswiderstandes erzeugen.

Kommen als Strahler 13 eine oder mehrere LED's und als fotosensitives Element 15 ein Fototransistor oder eine Fotodiode zum Einsatz, so bietet sich insbesondere für die fotosensitiven Elemente vorteilhaft deren Ausführung in SMD-Technik an.

Die in der vorstehenden Beschreibung, den Ansprüchen und den Figuren offenbarten Merkmale können sowohl einzeln als auch in beliebiger Kombination für die Verwirklichung der Erfindung in ihren verschiedenen Ausgestaltungen von Bedeutung sein.

## Patentansprüche

1. Berührungs- oder Näherungsschalter mit einer optoelektronischen Sensoranordnung mit einem Strahler (1), der mindestens eine LED umfasst und in einem lichtdurchlässigen LED-Gehäuse (2) angeordnet ist und einen Lichtstrahl (3) aussendet,
einem fotosensitiven Element (4) als Empfänger, das außerhalb des Strahlenganges des Lichtstrahles (3) des Strahlers (1) angeordnet ist, und mit
einer im Strahlengang des Lichtstrahles (3) angeordneten lichtdurchlässigen Fläche, die bei Berührung dieser lichtdurchlässigen Fläche oder bei Annäherung an diese lichtdurchlässige Fläche eine Reflexion des Lichtstrahles auf das fotosensitive Element (4) bewirkt,
wobei die lichtdurchlässige Fläche durch eine Kuppel des LED-Gehäuses (2) gebildet ist und das LED-Gehäuse (2) als Lichtleiter wirkt, und
wobei das fotosensitive Element (4) eine/n außerhalb des LED-Gehäuses (2), in Abstrahlrichtung des Strahlers (3) hinter dem LED-Gehäuse (2) in unmittelbarer Nähe des LED-Gehäuses (2) angeordnete/n Fotodiode oder Fototransistor umfasst.

2. Berührungs- oder Näherungsschalter nach Anspruch 1, **dadurch gekennzeichnet, dass** der Strahler (1) einen Lichtstrahl im sichtbaren Bereich erzeugt.

3. Berührungs- oder Näherungsschalter nach einem der vorangehenden Ansprüche mit einer elektronischen Steuereinheit (16) für die optoelektronische Sensoranordnung (12), die den Strahler (13) wahlweise zum Aussenden des Lichtstrahles als Licht-Messstrahl und zur Beleuchtung des Schalters (10) ansteuert und den Schalter (10) abhängig von dem Ausgangssignal des fotosensitiven Elements (15) betätigt.

4. Berührungs- oder Näherungsschalter nach Anspruch 3, **dadurch gekennzeichnet, dass** die elektronische Steuereinheit das fotosensitive Element (15) wahlweise als Reflexionssignal-Detektor oder als Umgebungslicht-Detektor (17) betreibt.

5. Berührungs- oder Näherungsschalter nach Anspruch 3 oder 4, **dadurch gekennzeichnet, dass** das fotosensitive Element (15) und der Strahler (13) von der elektronischen Steuereinheit (16) gemeinsam getaktet werden, wobei der Takt einen Messzyklus und einen Arbeitszyklus umfasst.

6. Berührungs- oder Näherungsschalter nach Anspruch 5, **dadurch gekennzeichnet, dass** im Messzyklus das fotosensitive Element (15) wahlweise als Umgebungslicht-Detektor (17) oder als Reflexionssignal-Detektor ansteuerbar ist, wobei der Strahler (13) im ersten Fall während des Messzyklus deaktiviert ist und im zweiten Fall während des Messzyklus mindestens einen Messimpuls abgibt.

7. Berührungs- oder Näherungsschalter nach Anspruch 5 oder 6, **dadurch gekennzeichnet, dass** während des Arbeitszyklus der Strahler (13) von der elektronischen Steuereinheit (16) zur Beleuchtung des Schalters (10) ansteuerbar ist.

8. Berührungs- oder Näherungsschalter nach den Ansprüchen 6 und 7, **dadurch gekennzeichnet, dass** in Abhängigkeit vom Ausgangssignal des als Umgebungslicht-Detektors (17) angesteuerten fotosensitiven Elementes (15) der Strahler (13) während des Arbeitszyklus zur Beleuchtung des Schalters (10) angesteuert wird.

9. Berührungs- oder Näherungsschalter nach den Ansprüchen 6 und 7, **dadurch gekennzeichnet, dass** bei Ansteuerung des fotosensitiven Elements als Reflexionssignal-Detektor der Strahler (13) während des Arbeitszyklus abhängig von dem Schaltzustand des Schalters (10) angesteuert wird.

10. Berührungs- oder Näherungsschalter nach Anspruch 8 oder 9, **dadurch gekennzeichnet, dass** zur Erzeugung von unterschiedlichen Helligkeiten des Strahlers (13) die Dauer der Aktivierung des Strahlers (13) im Arbeitszyklus als Anzeige für den Schaltzustand des Schalters (10) unterschiedlich ist als die Dauer der Aktivierung des Strahlers (13) als Beleuchtung für den Schalter (10).

11. Berührungs- oder Näherungsschalter nach Anspruch 8 oder 9, **dadurch gekennzeichnet, dass** zur Kennzeichnung, ob der Strahler (13) als Anzeige für den Schaltzustand des Schalters (10) oder als Beleuchtung für den Schalter (10) betrieben wird, die Farbe des Strahlers (13) umschaltbar ist.

12. Berührungs- oder Näherungsschalter nach einem der Ansprüche 3 bis 11, **dadurch gekennzeichnet, dass** das fotosensitive Element (15) durch die elektronische Steuereinheit (16) mit unterschiedlichen Empfindlichkeiten betrieben werden kann.

13. Berührungs- oder Näherungsschalter nach Anspruch 12, **dadurch gekennzeichnet, dass** die Empfindlichkeit des fotosensitiven Elementes (15) durch eine zeitweise Änderung dessen Arbeitswiderstandes veränderbar ist.

14. Berührungs- oder Näherungsschalter nach einem der vorangehenden Ansprüche, **dadurch gekennzeichnet, dass** die mindestens eine LED als Mehrfarben-LED ausgebildet ist.

## Claims

1. Touch or proximity switch comprising an optoelectronic sensor assembly including an emitter (1) comprising at least one LED and being arranged in a translucent LED housing (2) for emitting a light beam (3);
a photo sensitive element (4) as a receiver located outside of the light path of the light beam (3) of the emitter (1); and including
a translucent surface located in the light path of a light beam (3), the translucent surface causing a reflection of the light beam of the photosensitive element (4) upon touching or approaching the translucent surface,
wherein the translucent surface is formed by a dome of the LED housing (2) and the LED housing (2) acts as a light guide, and
wherein the photosensitive element (4) comprises a photo diode or photo transistor located outside of the LED housing (2), in the direction of the emitter (3) behind the LED housing (2) and proximate to the LED housing (2).

2. Touch or proximity switch according to claim 1, **characterized in that** the emitter (1) generates a light beam in the visible light range.

3. Touch or proximity switch according to one of the preceding claims, further comprising an electronic control unit (16) for the optoelectronic sensor assembly (12), the control unit selectively controlling the emitter (13) for emitting the light beam as a light measuring beam and for illuminating the switch (10) and activating the switch (10) as a function of the output signal of the photosensitive element (15).

4. Touch or proximity switch according to claim 3, **characterized in that** the electronic control unit selectively operates the photosensitive element (15) as a reflection signal detector or as an ambient light detector (17).

5. Touch or proximity switch according to claim 3 or 4, **characterized in that** the photosensitive element (15) and the emitter (13) are commonly clocked by the electronic control unit (16) wherein the clock comprises a measurement cycle and an operative cycle.

6. Touch or proximity switch according to claim 5, **characterized in that**, in the measurement cycle, the photosensitive element (15) is selectively controllable as an ambient light detector (17) or as a reflection signal detector wherein the emitter (13), in the former case, is deactivated during the measurement cycle and, in the latter case, outputs at least one measurement pulse during the measurement cycle.

7. Touch or proximity switch according to claim 5 or 6, **characterized in that**, during the operative cycle, the emitter (13) is controllable by the electronic control unit (16) for illuminating the switch (10).

8. Touch or proximity switch according to claim 6 and 7, **characterized in that**, during the operative cycle, the emitter (13) is controlled for illuminating the switch (10) as a function of the output signal of the photosensitive element (15) when controlled as said ambient light detector (17).

9. Touch or proximity switch according to claim 6 and 7, **characterized in that**, during the operative cycle, the emitter (13) is controlled as a function of the switching state of the switch (10) when the photosensitive element is controlled as said reflection signal detector.

10. Touch or proximity switch according to claim 8 or 9, **characterized in that**, for generating different intensities of the emitter (13), the duration of the activation of the emitter (13) in the operative cycle for indicating the switching state of the switch (10) is different from the duration of the activation of the emitter (13) used for illuminating the switch (10).

11. Touch or proximity switch according to claim 8 or 9, **characterized in that**, for indicating whether the emitter (13) is used for indicating the switching state of the switch (10) or for illuminating the switch (10), the colour of the emitter (13) can be switched.

12. Touch or proximity switch according to one of claims 3 to 11, **characterized in that** the photosensitive element (15) can be operated by the electronic control unit (13) using different sensitivities.

13. Touch or proximity switch according to claim 12, **characterized in that** the sensitivity of the photosensitive element (15) can be changed by temporarily changing its operative resistance.

14. Touch or proximity switch according to one of the preceding claims, **characterized in that**, at least one LED is formed as a multi-colour LED.

## Revendications

1. Commutateur de contact ou commutateur de proximité avec un dispositif de détection optoélectronique, avec une source de rayonnement (1) comportant au moins une diode électroluminescente, disposée dans un boîtier transparent pour diode (2) et émettant un faisceau lumineux (3),
un élément photosensible (4) en tant que récepteur, disposé en dehors du trajet du faisceau lumineux (3) de la source de rayonnement (1), et avec
une surface transparente disposée sur le trajet du faisceau lumineux (3), provoquant une réflexion du faisceau lumineux sur l'élément photosensible (4) suite à un contact avec ladite surface transparente ou à un rapprochement de ladite surface transparente,
la surface transparente étant formée par une coupole du boîtier pour diode (2), et le boîtier pour diode (2) agissant comme guide d'ondes lumineuses, et
l'élément photosensible (4) comprenant une photodiode ou un phototransistor disposé(e) à l'extérieur du boîtier pour diode (2), à proximité immédiate dudit boîtier pour diode (2), derrière le boîtier pour diode (2) dans la direction de rayonnement de la source de rayonnement (1).

2. Commutateur de contact ou commutateur de proximité selon la revendication 1, **caractérisé en ce que** la source de rayonnement (1) génère un faisceau lumineux dans la plage visible.

3. Commutateur de contact ou commutateur de proximité selon l'une des revendications précédentes, avec une unité de commande électronique (16) pour le dispositif de détection optoélectronique (12), laquelle commande la source de rayonnement (13) en option pour l'émission du faisceau lumineux en tant que faisceau lumineux de mesure ou pour l'éclairage du commutateur (10), et active le commutateur (10) en fonction du signal de sortie de l'élément photosensible (15).

4. Commutateur de contact ou commutateur de proximité selon la revendication 3, **caractérisé en ce que** l'unité de commande électronique actionne l'élément photosensible (15) en option comme détecteur de signal de réflexion ou comme détecteur de lumière ambiante (17).

5. Commutateur de contact ou commutateur de proximité selon la revendication 3 ou la revendication 4, **caractérisé en ce que** l'élément photosensible (15) et la source de rayonnement (13) sont synchronisés ensemble par l'unité de commande électronique (16), la synchronisation comprenant un cycle de mesure et un cycle de travail.

6. Commutateur de contact ou commutateur de proximité selon la revendication 5, **caractérisé en ce que** pendant le cycle de mesure, l'élément photosensible (15) peut être commandé en option comme détecteur de lumière ambiante (17) ou comme détecteur de signal de réflexion, la source de rayonnement (13) étant dans le premier cas désactivée pendant le cycle de mesure, et émettant au moins une impulsion de mesure pendant le cycle de mesure dans le second cas

7. Commutateur de contact ou commutateur de proximité selon la revendication 5 ou la revendication 6, **caractérisé en ce que** pendant le cycle de travail, la source de rayonnement (13) peut être commandée par l'unité de commande électronique (16) pour l'éclairage du commutateur (10).

8. Commutateur de contact ou commutateur de proximité selon les revendications 6 et 7, **caractérisé en ce qu'**en fonction du signal de sortie de l'élément photosensible (15) commandé comme détecteur de lumière ambiante (17), la source de rayonnement (13) est commandée pour l'éclairage du commutateur (10) pendant le cycle de travail.

9. Commutateur de contact ou commutateur de proximité selon les revendications 6 et 7, **caractérisé en ce qu'**en cas de commande de l'élément photosensible comme détecteur de signal de réflexion, la source de rayonnement (13) est commandée en fonction de l'état de commutation du commutateur (10) pendant le cycle de travail.

10. Commutateur de contact ou commutateur de proximité selon la revendication 8 ou la revendication 9, **caractérisé en ce que**, pour la génération de différentes luminosités de la source de rayonnement (13), la durée d'activation de la source de rayonnement (13) est différente pendant le cycle de travail en tant qu'indication pour l'état de commutation du commutateur (10), de la durée d'activation de la source de rayonnement (13) en tant qu'éclairage pour le commutateur (10).

11. Commutateur de contact ou commutateur de proximité selon la revendication 8 ou la revendication 9, **caractérisé en ce que** la couleur de la source de rayonnement (13) est commutable pour signaler si la source de rayonnement (13) est utilisée comme indication pour l'état de commutation du commutateur (10) ou comme éclairage pour le commutateur (10).

12. Commutateur de contact ou commutateur de proximité selon l'une des revendications 3 à 11, **caractérisé en ce que** l'élément photosensible (15) peut être mis en service avec différentes sensibilités par l'unité de commande électronique (16).

13. Commutateur de contact ou commutateur de proximité selon la revendication 12, **caractérisé en ce que** la sensibilité de l'élément photosensible (15) est modifiable par variation temporaire de sa résistance de travail.

14. Commutateur de contact ou commutateur de proximité selon l'une des revendications précédentes, **caractérisé en ce que** la ou les diodes électroluminescentes sont réalisées comme diodes à plusieurs couleurs.
